(19) Europäisches Patentamt
European Patent Office
Office européen des brevets

(11) Publication number: **0 031 906**
**B1**

(12) # EUROPEAN PATENT SPECIFICATION

(45) Date of publication of patent specification: **22.02.84**

(51) Int. Cl.³: **G 01 R 31/34,** G 01 M 13/04, G 05 D 13/62

(21) Application number: **80107611.8**

(22) Date of filing: **04.12.80**

(54) **Method and apparatus for determining friction associated with an electric motor.**

(30) Priority: **31.12.79 US 108738**

(43) Date of publication of application:
**15.07.81 Bulletin 81/28**

(45) Publication of the grant of the patent:
**22.02.84 Bulletin 84/8**

(84) Designated Contracting States:
**DE FR GB**

(56) References cited:
**US - A - 3 950 682**
**US - A - 4 091 662**

(73) Proprietor: **International Business Machines Corporation**
**Old Orchard Road**
**Armonk, N.Y. 10504 (US)**

(72) Inventor: **Nielson, Marlin Craig**
**1208 Fern Circle**
**Broomfield Colorado 80020 (US)**

(74) Representative: **Lancaster, James Donald**
**IBM United Kingdom Patent Operations Hursley Park**
**Winchester, Hants, SO21 2JN (GB)**

**EP 0 031 906 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

# Method and apparatus for determining friction associated with an electric motor

## Background of the invention

### 1. Field of the invention

This invention relates to a method and an apparatus for determining friction associated with an electric motor. The friction may be monitored while the motor is free running, or coupled to drive a mechanism.

### 2. Description of prior art

The use of electric motors for driving electromechanical systems, such as machines for transporting a load or weight, paper feed devices, etc. are well known in the prior art. The motors may be servo-controlled so that precise motion is transmitted to the load. The input energy to the motor should be of sufficient magnitude to overcome the frictional force associated with the system and at the same time perform the intended useful work such as transporting a load. Knowing the frictional force associated with a particular system can enable the optimization of power needed to drive a particular system to overcome the frictional force.

The frictional force, or change in the magnitude thereof, associated with a system can be used to predict an impending failure in the system. For example, if the bearings in a system are beginning to wear, then by monitoring the change in the friction, one may known when to change the bearing prior to a bearing breakdown of the system.

In view of the above, there is a clear need for a device which is able to accurately measure the friction associated with a motor and/or electromechanical system. Moreover, the measuring device should be able to measure friction dynamically. As such, as the frictional characteristics of a system change due to age, worn parts, etc. the calculated value will be more accurate. The calculated value can be used for antifriction compensation or for maintaining reliability, serviceability and availability (RAS) for the system.

The effect of friction on an electromechanical system is exemplified in U.S. Patent 3,916,279. In that system a controlled motor is used for lifting a load coupled through a pulley on the shaft of the motor. A friction simulating circuit generates a signal which compensates for the friction associated with the system. The design of the simulating circuit is based on a statistical prediction of the friction. Any deviation from the predicted value reduces the effectiveness of the circuit.

U.S. Patent 4,091,662 describes apparatus for testing electric motors. An input signal is generated to drive the motor and to produce a synchronous rotor speed signal, and the motor speed is monitored to generate an actual rotor speed signal, the difference between the two rotor speed signals being obtained in the process of deriving the per unit slip of the motor under test. This patent is acknowledged in the introductory part of claims 1 and 2.

The invention is defined in the method claim 1 and in the apparatus claim 2.

The features and advantages of the invention will be apparent from the following more particular description of the preferred embodiment of the invention, as illustrated in the accompanying drawings.

## Brief description of the drawings

Fig. 1 shows a block diagram of an electromechanical system, including a motor, in accordance with the teachings of the present invention.

Fig. 2 shows a logging system suitable for use with Fig. 1 to indicate excessive friction in the system.

## Detailed description

Referring now to Fig. 1 of the drawings, an electrical drive system 10 is operatively coupled to a machine or process indicated by block 12. The machine or process can be any machine or process known in the art, such as a feed-through scanner. The electrical drive system 10 includes a motor operatively coupled to a power amplifier. The power amplifier supplies the necessary electrical energy which is necessary to drive the motor so as to effectuate the necessary motion in the machine 12. By way of example, if machine 12 is a paper feed mechanism, the output shaft from the motor is coupled through a gear reducing mechanism (not shown) which drives the paper through the machine. It is worthwhile noting that although the system described hereinafter will be a digital system, this should be construed as exemplary since it is within the skill of the art to convert the digital system into an analog system without departing from the scope of the present invention. Still referring to Fig. 1, link 14 couples the machine to the electrical drive system 10. In this type of system, the friction which is present in the machine and the electrical drive system is critical to the proper operation of the system. This being the case, the invention described hereinafter measures the friction associated with the system. It should also be noted that the invention to be described will measure the friction associated with the electrical drive system 10, and in particular, the motor, if a machine such as 12 is not coupled to the motor shaft. In this application the invention is useful for measuring friction associated with a motor on a motor production line.

Still referring to Fig. 1, a signal generating means 16 generates a feed forward control signal R on conductor 18. The feed forward control signal R is a positional signal whose magnitude is such that when it is processed by the elements in the feed forward loop of the system and applied to the motor, the shaft of the motor rotates at a predetermined velocity. The signal generating means 16 is a 16-bit UP counter having two controlled inputs 20 and 22, respectively. The controlled inputs accept control signals outputted from control logic means 24 on conductors 26 and 28 respectively. The signal on conductor 26 initializes the counter so that the output control signal R=0. The successive signals on conductor 28 step the counter. This being the case, the output signal is in effect a ramp function. Of course, there are other ways of generating a ramp function without departing from the scope of the present invention. The control logic means 24 may be a series of combinatorial logic or a conventional microcomputer programmed to output control signals at predetermined periods of time. The control logic means 24 is governed by two input signals on conductors 30 and 32 respectively. The signal on conductor 30 is a start signal and in effect enables the control logic means 24 to function. Likewise, the signal on conductor 32 deactivates or stops the control logic means 24 from functioning. As was stated previously, a ramp positional function R is generated by signal generating means 16 and is outputted on conductor 18. The signal is fed into summing means 36. As will be explained hereinafter, the positional signal is algebraically summed with a feedback position signal generated on conductor 38 and outputs an error signal $E_1$ on conductor 40. Algebraically stated:

$$E_1=R-C$$

where:

R=the ramp positional signal

C=the feedback position signal.

In the preferred embodiment of this invention the summing means 36 is a 16-bit subtractor. The error signal E1 on conductor 40 is next fed into digital filtering means 44. The digital filtering means 42, details of which will be given hereinafter, includes a 16-bit digital filter 44 whose output E2 is fed over conductor 46 into an 8-bit latch means 48. The digital filter 42 controls the amplitude and the phase of generated error E1 so that the output error value E2 gives a value which is equivalent to the friction in the motor and/or machine 12. The digital filter 44 is controlled by a first clock hereinafter called CLK1 signal on conductor 50 and an initialization signal on conductor 52. Both signals are generated from control logic means 24. Similarly a clear signal on conductor 54 clears latch 48 while a control clock signal hereinafter called CLK2 on conductor 56 transfers the signal on conductor 46 into the latch 48.

The error value is best representative of the true friction in the motor when the value is achieved with the motor running at steady state. As such the frictional error value on conductor 58 is fed over conductor 60 into a storage means or accumulator 62. The accumulator 62 allows the frictional value to be averaged over a predetermined number of machine cycles. The control signals to accumulator 62 are generated by control logic means 24 over conductors 64 and 66, respectively. By way of example, the signal on conductor 64 clears the contents of the accumulator while the signal on conductor 66 enables the accumulator to receive data from conductor 60. The output from the accumulator is given on conductor 68 and represents the average friction over a predetermined number of machine cycles associated with the electromechanical system which includes the electrical drive system 10 and/or machine 12. As will be described hereinafter, the frictional value on conductor 68 may be logged into a permanent log or memory under the control of a control pulse on conductor 70.

Still referring to Fig. 1, the error signal E2 which is outputted on conductor 58 is converted by a conventional digital to analog converter (DAC) 72 and is used for driving the motor 10. As was stated previously, the positional signal R tends to rotate the motor shaft. As the shaft of the motor begins to rotate, a measuring means 73 measures the velcoity of the rotating shaft. In the preferred embodiment of this invention, the measuring means 73 is a two-phase digital tachometer coupled to the shaft of the motor. The digital tachometer measures both velocity and direction of rotation. The use of a digital tachometer for measuring velocity and/or directional rotation is well known in the art. Therefore, the details of such a tachometer will not be described. Suffice it to say that the tachometer provides two 90° phase-shifted output signals which are merged in a utilization circuit to output direction and velocity pulse signals on conductor 74. The direction of motor rotation is sensed by direction sensor means 76. The direction sense means 76 generates an UP signal on conductor 78 or a DOWN signal on conductor 80. The signal on conductor 78 or 80 respectively forces the UP-DOWN counting means 82 to count upwards or downwards depending on the direction of the rotation of the motor shaft, thus effectively integrating the tachometer output to produce a positional output. The output from the UP-DOWN counter is outputted on conductor 38 and is the feedback signal which is algebraically summed with the feed forward positional signal. Initialization of the UP-DOWN counter is achieved by a signal on conductor 81 which is generated from the control logic means 24.

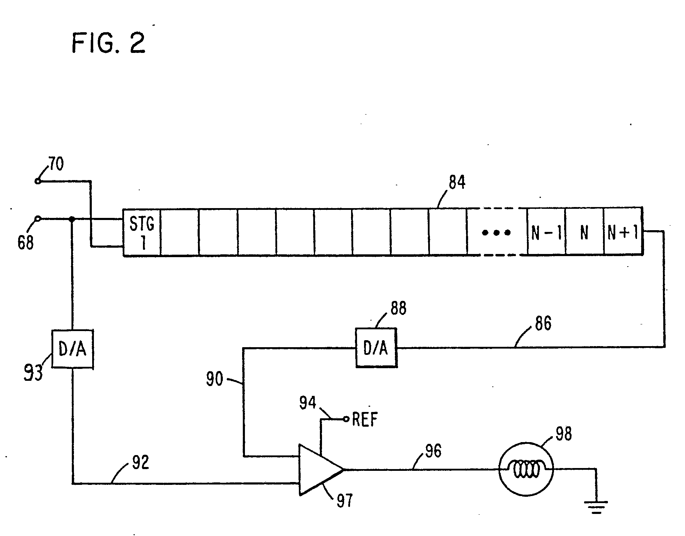

Referring now to Fig. 2 a logging system suitable for using the frictional values generated on conductor 68 is shown. However, these error values may be stored simultaneously in the permanent memory of a computer as part of an error routine and is printed out so that it can be reviewed as part of the reliability, serviceability and availability (RAS) routine. Also, the error values can be used to inform

an operator of the increase in friction when it passes a predetermined value. To this end, the frictional value outputted from accumulator 62 on conductor 68 is placed into stage one (STG1) of a multistage shift register 84. Entry of data into the shift register and/or sequential shifting of data from one stage to the next, is controlled by clock pulses outputted from control logic means 24 on conductor 70. The system is configured so that controlled pulses on conductor 70 force the shift register to shift one position to the right. As such the information which was first placed in stage one of the shift register after a number of shifts is now present in stage N+1 of the register. With one of the shifts, the information in stage (N+1) is fed over conductor 86 into digital to analog (D/A) converter 88. The digital to analog converter converts the digital signal into an analog signal and outputs the same on conductor 90. The signal on conductor 90 is compared with a present analog signal on conductor 92 produced by D/A converter 93 to output a signal on conductor 96 when the difference between the signals on conductor 90 and 92 respectively exceed a predetermined reference signal on terminal 94 of comparator means 97. In the preferred embodiment of the present invention, the comparator means 97 is an operational amplifier with a reference terminal 94 which is used to connect the referenced voltage. Whenever the difference between the value on conductor 90 and conductor 92 exceeds that reference, a voltage pulse is outputted on conductor 96. Conductor 96 is operatively coupled to a lamp 98. The signal on conductor 96 illuminates the filament of the lamp and as such, warns an operator when the change friction in time in the system exceeds a tolerable value.

It is worthwhile noting that the comparison in the comparator is done between the last stage of the shift register and a present value generated. This means that the last read frictional value is always compared with a present frictional value to indicate whether or not the variation rate of the frictional value in the system is running at an accepted level. A comparison against a constant value could also be used to signal that the friction has surpassed some preset value.

The use of a controlled closed loop servo to extract friction values associated with a motor and/or motor driven system may be explained mathematically. The below described mathematical model describes a specific example. Of course, the teaching may be used to extend to any type of controlled closed loop servo system.

In the mathematical description let Z(G(S)), normally referred to as G(Z), is the Z-transform of a time function g(t) and g(s) is the Laplace Transform of the time function *g*(t).

1. Static friction ($\tau_s$) (striction):
   Static friction, sometimes called starting friction, is the resistance to movement at zero velocity.
2. Coulomb friction ($\tau_F$)
   Coulomb friction has a constant value for all velocity values of the same sign.
3. Viscous friction ($\tau_B$)
   Viscous friction is a linear function of the velocity.

The combination of the coulomb and viscous friction torques forms a nonlinear function which does not have a closed form Laplace transform representation. However, if the value of the radian velocity does not change sign or vanish for a particular input and time interval, then the coulomb friction torque appears as a constant torque function which has a closed form Laplace transform. As is expected, the nonlinear aspect of the coulomb friction leads to nonlinear behavior of the control system about zero velocity.

A dynamic equation for an electromechanical drive system with friction is as follows:

$$K\,i-\tau_F=J\frac{d\omega}{dt}+B\omega \qquad \text{(Equation 1)}$$

where

k=motor torque constant
$\tau_F$=coulomb friction torque
J=moment of inertia of motor and load
B=viscous friction
$\omega$=angular velocity of the motor
i=motor armature current

The Laplace transform of equation 1 with zero initial condition is:

$$KI(s)-\frac{\tau F}{S}=(J\,s+B)W(s)$$

where I(s) and W(s) are the Laplace transforms of the motor current and angular velocity respectively. This can be expressed as:—

$$W(s)=\frac{KI(s)}{Js+B}-\frac{\tau_F}{s(Js+B)} \qquad \text{(Equation 2)}$$

First, viscous friction at steady state will be investigated by setting the coulomb friction torque to zero and taking the Z-transform of the system:

$$E_2(z)=\frac{D(z)\,R(z)}{1+D(z)\,HG(z)}$$

where:
D(z) is the Z-transfer function of the digital filter
R(z) is the Z-transform of the input ramp, and
HG(z) is the Z-transfer function of the combined latch (48 i.e. H), the motor and machine combination, the digital tachometer and the UP/DOWN counter (10, 12, 73, 82 i.e. G);

the notation HG(z) means Z(H(s)G(s)), and in general does not equal H(z) G(z) which means Z(H(s)) times Z(G(s)). The steady state error signal $e_2(\infty)$=limit as t approaches infinity $e_2(t)$, and by the final value theorem:

$$e_2(\infty)=\lim_{Z\to 1}\frac{Z-1}{Z}E2(z)$$

$$=\lim_{Z\to 1}\frac{Z-1}{Z}\,\frac{D(z)\,R(z)}{1+D(z)\,HG(z)}$$

$$=\lim_{Z\to 1}\frac{Z-1}{Z}\,\frac{R(z)}{\frac{1}{D(z)}+HG(z)}$$

If the limit as z approaches 1 of 1/D(z) equals zero, then we could eliminate parameters of D(z) from the limit.

$$D(z)=10\cdot 2\left[\frac{Z^2-1.82+0.82}{(Z-1)\,(Z+0.82)}\right] \text{ and}$$

is unbounded when z approaches 1, thus allowing us to eliminate 1/D(z) from the limit. Therefore, using the D(z):

$$e_2(\infty)=\lim_{Z\to 1}\frac{Z-1}{Z}\,\frac{R(z)}{HG(z)}$$

It can be shown that the transfer function for the zero order hold and second order plant is:

$$HG(z)=\frac{AK}{B^2}\;\frac{BT(z-\exp(-bT))-J(z-1)(z-\exp(-bT))-J(z-1)^2}{(z-1)(z-\exp(-bT))}$$

Where b is the mechanical time constant (B/J) and T is the sampling interval in seconds. Next by taking the limit of the last two terms in the numerator as z approaches 1:

$$HG'(z)=\frac{AK}{B}\,\frac{T}{Z-1}$$

Finally,

$$e2(\infty)=\lim_{z\to 1}\frac{Z-1}{z}\,\frac{R(z)}{HG'(z)}=\frac{(z-1)^2}{zT}\,\frac{B}{AK}\,R(z)=\frac{(z-1)^2}{zT}\,\frac{B}{AK}R(z)$$

By choosing

$$R(z)=\frac{zT}{(z-1)^2}(r_o)$$

which happens to be the Z-transform of the ramp forcing function of amplitude $r_o$, we get:

$$e2(\infty)=\frac{B}{AK}(r_o)$$

This says that by driving the control system with a ramp input of $r_0$ and observing the steady state error signal, e2(∞) we can measure a value proportional to B, the viscous friction.

The total friction at steady state will now be determined. Now we can consider the case where the coulomb friction torque, $\tau_F$, does not equal zero. As stated earlier, the coulomb friction appears as a constant torque for angular velocities either positive or negative and never crossing the zero velocity point. Taking the Z-transform of the system:

$$E2(z)=\frac{D(z)\,R(z)}{1+D(z)\,HG(z)}+\frac{D(z)\,\tau_F G(z)}{1+D(z)\,HG(z)}$$

Where $\tau=\tau(z)$, the friction torque, and $\tau_F G(z)=Z(\tau(s)G(s))$ as explained earlier. Again by applying the final value theorem on $e_2(t)$ and using the result of the previous section:

$$e2(\infty)=\lim_{z\to 1}\frac{z-1}{z}E_2(z)=\frac{B(r_o)}{AK}+\lim_{z\to 1}\frac{z-1}{z}\frac{D(z)\,\tau_F G(z)}{1+D(z)\,HG(z)}=\frac{B(r_o)}{AK}+\lim_{z\to 1}\frac{z-1}{z}\frac{\tau_F G(z)}{HG(z)}$$

It can be shown that where $\tau_F$ is a unit step function with an amplitude $\tau/K$:

$$\tau_F G(z)=\frac{\tau_F}{AK}\frac{z}{z-1}HG(z)$$

Therefore,

$$e2(\infty)=\frac{B(r_o)+\tau_F}{AK} \qquad \text{Equation 3}$$

This result extends the result of the previous section. It says that by driving discrete time system with a ramp input, we can obtain a value proportional to the total system friction. Both proportionality constants, A and K, are gain terms (amplifier gain and motor torque constant respectively).

If desired, the values of B and $\tau_F$ can be determined by using two distinct velocities of the same sign, say r and p. If the steady state errors measured at the two velocities are e and $\varepsilon$ respectively, then:

$$e=\frac{Br+\tau_F}{AK};\quad \varepsilon=\frac{Bp+\tau_F}{AK} \qquad \text{Equation 4}$$

Subtracting $\varepsilon$ from e in Equation 4 yields:

$$e-\varepsilon=\frac{B(r-p)}{AK} \qquad \text{Equation 5}$$

Solving Equation 5 for the viscous friction, B yields:

$$B=AK\frac{e-\varepsilon}{r-p} \qquad \text{Equation 6}$$

Substituting the result of Equation 6 into the first member of Equation 4 yields the result for the coulomb friction:

$$\tau_F = AK\left(e - r\frac{e-\varepsilon}{r-p}\right)$$

As was stated previously, the error $E_1$ on conductor 40 (Fig. 1) is modified by filter 44 to output a signal on conductor 46. The signal on conductor 46 is proportional to the friction in the system. In the preferred embodiment of the present invention a digital filter is used. A mathematical expression for the digital filter or compensator is as follows:

$$D(z) = \frac{10.2z^2 - 18.45z + 8.4}{z^2 - 0.1818z - 0.8182} \qquad \text{Equation 7}$$

Equation 7 is the complete compensator for the position control system. To implement D(z) in a conventional processor, it must be converted to a difference equation in the time domain. If the input to the compensator is $E_1(z)$ and the output is $E_2(z)$, then:

$$D(z) = \frac{E_2(z)}{E_1(z)} = \frac{10.2z^2 - 18.45z + 8.4}{z^2 - 0.1818z - 0.8182} \qquad \text{Equation 8}$$

After multiplying the numerator and denominator by $1/z^2$, Equation 8 becomes:

$$\frac{E_2(z)}{E_1(z)} = \frac{10.2 - 18.45/z + 8.4/z^2}{1 - 0.1818/z - 0.8182/z^2} \qquad \text{Equation 9}$$

After cross multiplying, Equation 9 becomes:

$$E_2(z) - 0.1818E_2(z)/z - 0.8182E_2(z)/z^2 = 10.2E_1(z) - 18.45E_1(z)/z + 8.4E_2(z)/z^2 \qquad \text{Equation 10}$$

Finally, after taking the inverse Z-transform, Equation 10 becomes:

$$10.2e_1(n) - 18.45e_1(n-1) + 8.4e_1(n-2) = e_2(n) - 0.1818e_2(n-1) - 0.8182e_2(n-2) \qquad \text{Equation 11}$$

where n is the sampling time at instant $t_n$.

Since the desired result is the output at the current sample time, namely $e_2(n)$:

$$e_2(n) = 10.2e_1(n) - 18.45e_1(n-1) + 8.4e_1(n-2) + 0.1818e_2(n-1) + 0.8182e_2(n-2) \qquad \text{Equation 12}$$

Equation 12 is in a form that can be realized using a conventional processor or microcomputer. The equation says that the error output at a sample time is the linear combination of the error input at the current sample time, the error inputs at the two previous sample times, and the error outputs at the two previous sample times.

The above apparatus and method allows one to accurately determine the friction in an electromechanical system such as a paper drive system (the controlled plant). The friction value requires adaptive determination because its value will vary from one machine to another as well as with time for any one machine. Knowledge of the friction in the controlled plant will have the following beneficial consequences:

The processor or controller can save the friction value in nonvolatile storage or send the value to the host for diagnostic purposes. An erratic or unusually large friction value would indicate a possible problem with the scanner drive system.

An accurate friction value could minimize transients in a phase locked velocity control when it switches from open loop acceleration to closed loop velocity control. The friction value determines the amount of bias applied to the phase locked loop.

The friction value, again applied as a bias, will minimize the velocity ripple in the phase locked loop velocity control under steady state conditions by cancelling the average friction torque in the scanner drive system.

## Claims

1. Method for determining the steady state friction value associated with an electric motor in which an input signal (18) is generated which imparts a velocity to the motor (10), and a signal indicative of the velocity of the motor is generated by monitoring the velocity of the motor, characterised in that said input signal (18) is generated as a ramp function (R) which is a position

signal, said ramp function being subtracted from another position signal (c) to generate an error signal (E1), said error signal (E1) being filtered to produce a filtered error signal (E2) which drives the motor, the signal indicative of the velocity of the motor being used to generate said other position signal (c), the filtering of said error signal (E1) being carried out in such a manner that said filtered error signal (E2) represents the steady state friction value associated with the motor.

2. Apparatus for determining the steady state friction value associated with an electric motor comprising first means (16) for generating an input signal which imparts a velocity to the motor (10), and second means (73) to monitor the velocity of the motor and to generate a signal indicative of the velocity of such motor, characterised in that said first means (16) generates a ramp function (R) which is a position signal, the apparatus further including summing means (36) whereby said ramp function is subtracted from another position signal (c) to generate an error signal (E1), filtering means (44) responsive to the error signal to produce a filtered error signal (E2) which drives the motor, and closed loop feedback means (73, 82) comprising said second means (73) and responsive to the motor velocity to generate said other position signal (c), the filtering means being so designed that said filtered error signal (E2) represents the steady state friction value associated with the motor.

3. Apparatus as claimed in claim 2 in which said first means (16), said summing means (36), said filtering means (44) and said closed loop feedback means (73, 82) are digital.

4. Apparatus as claimed in claim 3 including a latch (48) intermediate said filtering means (44) and said motor (10), and an accumulator (62) fed by said latch, said accumulator generating the average steady state friction value from a predetermined number of filtered error signals sequentially latched in said latch (48).

5. Apparatus as claimed in claim 4 including means (84) for logging said average steady state friction value, and means (97) for comparing a present average steady state friction value with a previously logged value.

**Patentansprüche**

1. Verfahren zur Bestimmung des Dauer-Reibungswertes eines Elektromotors, in welchem ein Eingangssignal (18) erzeugt wird, das dem Motor (10) eine Geschwindigkeit liefert, und wo durch das Steuern der Motorgeschwindigkeit ein die Geschwindigkeit des Motors anzeigendes Signal erzeugt wird, dadurch gekennzeichnet, daß das obengenannte Eingangssignal (18) als eine Sägezahnfunktion (R) erzeugt wird, die ein Positionssignal darstellt, wobei die obergenannte Sägezahnfunktion von einem anderen Positionssignal (c) abgezogen wird, um ein Fehlersignal (E1) zu erzeugen, das gefiltert wird, um ein den Motor antreibendes gefiltertes Fehlersignal (E2) zu liefern, wobei das die Motorgeschwindigkeit anzeigende Signal zur Bildung des anderen Positionssignals (c) verwendet wird, und wobei das Fehlersignal (E1) so gefiltert wird, daß es den Dauer-Reibungswert des Motors darstellt.

2. Vorrichtung zur Bestimmung des Dauer-Reibungswertes eines Elektromotors, mit ersten Mitteln (16) zur Erzeugung eines Eingangssignals, das dem Motor (10) eine Geschwindigkeit mitteilt, sowie mit zweiten Mitteln (73) zur Steuerung der Motorgeschwindigkeit und zur Bildung eines die Motorgeschwindigkeit anzeigenden Signals, dadurch gekennzeichnet, daß die obengenannten ersten Mittel (16) eine ein Positionssignal darstellende Sägezahnfunktion (R) bilden, und mit Summierungsmitteln (36), die die obengenannte Sägezahnfunktion von einem anderen Positionssignal (c) zur Bildung eines Fehlersignals (E1) abziehen, und mit einem auf das Fehlersignal ansprechenden Filter (44) zur Erzeugung eines gefilterten, den Motor antreibenden Fehlersignals (E2), sowie mit das obengenannte zweite Mittel (73) einschließender in sich geschlossener Rückkopplung (73, 82), die auf die Motorgeschwindigkeit anspricht zur Erzeugung des anderen Positionssignals (c), wobei der Filter so ausgelegt ist, daß das gefilterte Fehlersignal (E2) den Dauer-Reibungswert des Motors darstellt.

3. Vorrichtung nach Anspruch 2, in welcher das erste Mittel (16), das obengenannte Summierungsmittel (36), der Filter (44) und die genannte in sich geschlossene Rückkopplung (73, 82) digital sind.

4. Vorrichtung nach Anspruch 3, mit einer Verriegelungsschaltung (48) direkt bei dem Filter (44) und dem Motor (10), und mit einem von der Verriegelungsschaltung betriebenen Akkumulator (62), der den durchschnittlichen Dauer-Reibungswert bildet von einer bestimmten Anzahl gefilterter Fehlersignale, die in der obengenannten Verriegelungsschaltung (48) nacheinander verriegelt werden.

5. Vorrichtung nach Anspruch 4, mit Mitteln (84) zur Erfassung des obengenannten durchschnittlichen Dauer-Reibungswertes, sowie mit Mitteln (97) zum Vergleichen eines augenblicklichen durchschnittlichen Dauer-Reibungswertes mit einem zuvor erfaßten Wert.

**Revendications**

1. Procédé pour déterminer la valeur de la friction à l'état stable associée à un moteur électrique dans lequel sont engendrés un signal d'entrée (18) qui communique une vitesse au moteur 10, et un signal indiquant la vitesse du moteur par contrôle de la vitesse du moteur, caractérisé en ce que ledit signal d'entrée (18) est engendré en tant que fonction de rampe (R) qui est un signal de position, ladite fonction de rampe étant soustraite d'un autre signal de position (c) pour engendrer un signal d'erreur

(E1), ledit signal d'erreur (E1) étant filtré pour produire un signal d'erreur filtré (E2) qui entraîne le moteur, le signal indiquant la vitesse du moteur étant utilisé pour engendrer ledit autre signal de position (c), le filtrage dudit signal d'erreur (E1) se faisant de sorte que ledit signal d'erreur filtré (E2) représente la valeur de la friction stable associée au moteur.

2. Appareil pour déterminer la valeur de la friction à l'état stable associée à un moteur électrique comprenant des premiers moyens (16) pour engendrer un signal d'entrée qui communique une vitesse au moteur (10), et des seconds moyens (73) pour contrôler la vitesse du moteur et pour engendrer un signal indiquant la vitesse de ce moteur, caractérisé en ce que lesdits premiers moyens (16) engendrent une fonction de rampe (R) qui est un signal de position, l'appareil comprenant en outre des moyens de sommation (36) au moyen desquels ladite fonction de rampe est soustraite d'un autre signal de position (c) pour engendrer un signal d'erreur (E1), des moyens de filtrate (44) sensibles au signal d'erreur pour produire un signal d'erreur filtre (E2) qui entraîne le moteur, et des moyens de réaction à boucle fermée (73, 82) constituant lesdits seconds moyens (73) et sensibles à la vitesse du moteur pour engendrer ledit autre signal de position (c), les moyens de filtrage étant conçus de sorte que ledit signal d'erreur filtré (E2) représente la valeur de la friction à l'état stable associée au moteur.

3. Appareil selon la revendication 2, dans lequel lesdits premiers moyens (16), lesdits moyens de sommation (36), lesdits moyens de filtrage (44) et lesdits moyens de réaction à boucle fermée (73, 72) sont numériques.

4. Appareil selon la revendication 3 comprenant une bascule à verrouillage (48) entre lesdits moyens de filtrate (44) et ledit moteur (10), et un accumulateur (62) alimenté par ladite bascule à verrouillage, ledit accumulateur engendrant la valeur moyenne de la friction à l'état stable à partir d'un nombre prédéterminé de signaux d'erreur filtrés verrouillés en séquentiel dans ladite bascule (48).

5. Appareil selon la revendication 4, comprenant des moyens 84 pour consigner ladite valeur moyenne de la friction à l'état stable, et des moyens (97) pour comparer une valeur présente moyenne de la friction à l'état stable à une valeur consignée préalablement.

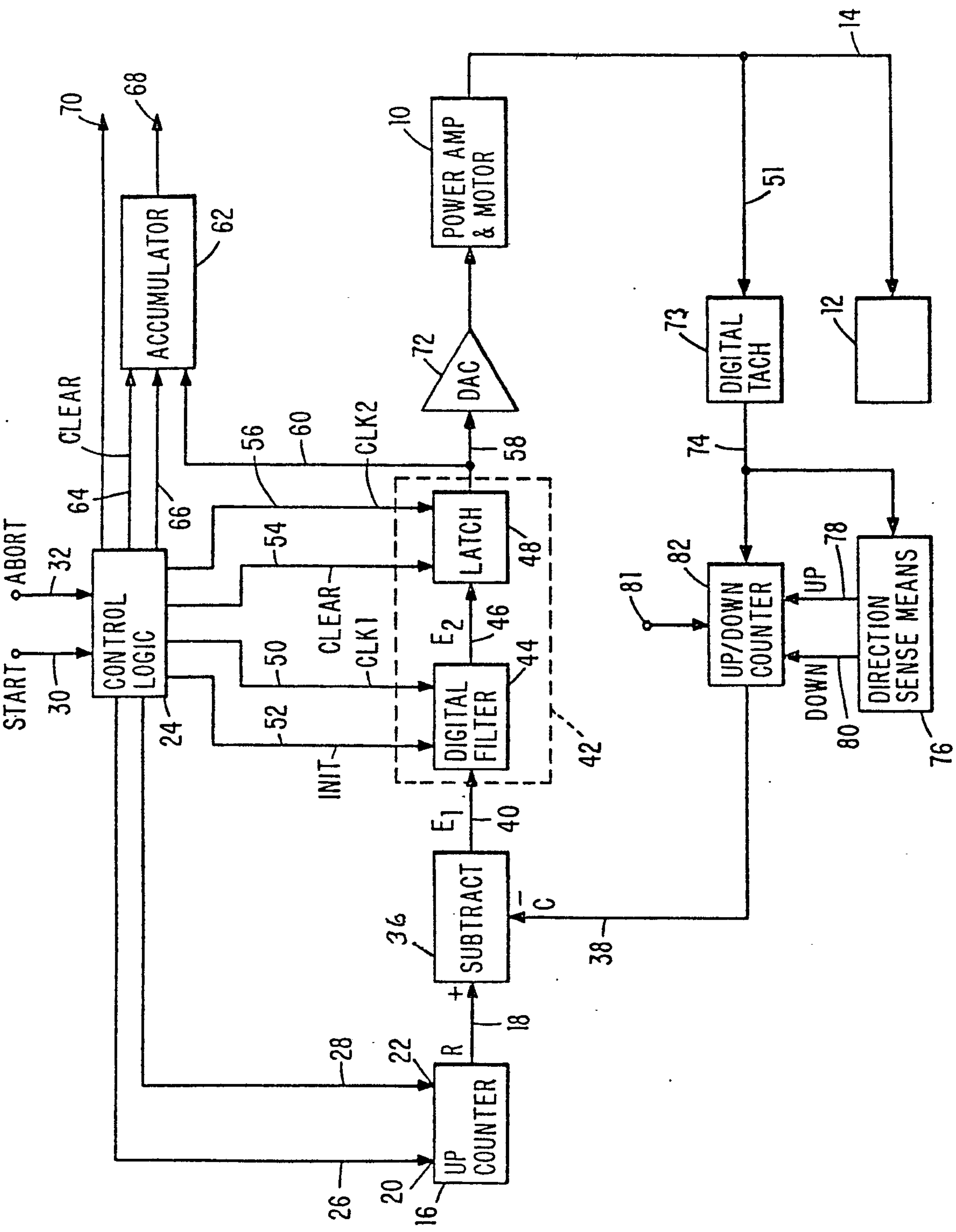
START
30
ABORT
32
CONTROL LOGIC
24
ACCUMULATOR
62
CLEAR
64
66
70
68
UP COUNTER
16
20
22
26
28
R
18
+
SUBTRACT
36
C
38
E1
40
DIGITAL FILTER
44
E2
46
LATCH
48
42
INIT
52
CLK1
50
CLEAR
54
CLK2
56
60
58
DAC
72
POWER AMP & MOTOR
10
14
51
DIGITAL TACH
73
12
74
UP/DOWN COUNTER
82
81
UP
78
DOWN
80
DIRECTION SENSE MEANS
76

FIG. 1

FIG. 2